# EUROPEAN PATENT SPECIFICATION

(11) **EP 0 648 628 B1**
(45) Date of publication and mention of the grant of the patent: **09.09.1998**
(21) Application number: 94307543.2
(22) Date of filing: 14.10.1994
(51) Int. Cl.: B60J 7/057, E05F 15/00

(54) **Movable-window safety device**
Sicherheitsgerät für ein bewegbares Fenster
Appareil de sécurité pour un lève-glace

(30) Priority: 18.10.1993 GB 9321484; 27.10.1993 GB 9322165; 09.12.1993 GB 9325242; 24.12.1993 GB 9326467; 11.01.1994 GB 9400407
(43) Date of publication of application: 19.04.1995
(73) Proprietor: DRAFTEX INDUSTRIES LIMITED, Edinburgh EH2 3AP, Scotland (GB)
(72) Inventor: Heller, Norbert, 47929 Grefrath (DE); Hanndorf, Klaus, 47805 Krefeld (DE); Stockschlager, Alfons, 41749 Viersen (DE)
(74) Representative: Foster, David Martyn

(56) References cited:
- EP-A- 0 062 568
- EP-A- 0 377 226
- DE-A- 3 521 004
- DE-A- 3 527 405
- DE-A- 3 736 400
- DE-A- 4 036 465

## Description

The invention relates to a system for controlling a system for controlling a power-driven window movable in a window opening between closed and opened positions, comprising electrical oscillating means for producing an electrically oscillating output, electrically conductive means adapted to be positioned adjacent to the window opening, connecting means connecting the conductive means to the electrical oscillating means such that the presence of a part of the human body at or not more than a predetermined distance from the electrically conductive means produces a change in the frequency of the electrically oscillating output, detecting means responsive to the said change in frequency to produce an output signal, and output means responsive to the output signal for interrupting movement of the window glass towards the closed position.

Such a system is shown, for example, in US-A-4 453 112. In this known system, a capacitive pick-up responds to the presence of part of the human body in the window opening by changing the frequency of an electrical oscillator. A detecting circuit measures the rate of change of this frequency. If the rate of frequency change is above a predetermined value, closing movement of the window glass is stopped. However, such a system, which requires accurate measurement of rate of frequency change, may be adversely affected by component ageing, changes in supply voltage and the like. The invention aims to mitigate this problem.

Accordingly, the known system is characterised, in accordance with the invention, in that the detecting means comprises a source producing a reference frequency, and comparing means for comparing the frequency of the electrically oscillating output with the reference frequency to produce the said output signal.

In the invention, therefore, the frequency of the electrically oscillating output is always compared with a stable reference frequency.

The invention in another aspect also relates to a system for controlling a power-driven window glass slidable in a window frame, comprising electrically conductive means adapted to be mounted in use adjacent to the window opening so as to be physically moved by direct or indirect contact with part of the human body positioned between the moving window glass and its frame during power-driven closure of the window, electrical circuit means connected to the electrically conductive means so as to respond to the said movement of the electrically conducted means and to produce a corresponding output, detecting means responsive to the output to produce a control signal, and control means responsive to the control signal for interrupting power-driven movement of the window glass.

Such a system is shown, for example, in DE-A-3 724 085. However such a system requires electrical contact to be made between two conductors. Such a system may be adversely affected by ageing and similar effects which may alter the force necessary to achieve the necessary contact.

According to this aspect of the invention, therefore, such a system is characterised in that the electrical circuit means incorporates an electrical oscillator and in that the electrically conductive means is connected in the tuned circuit of the oscillator whereby the said movement of the electrically conductive means changes the frequency of the oscillator to produce the said output.

Safety systems for interrupting the movement of a power-driven window in a motor vehicle, to prevent human injury, will now be described, by way of example only, with reference to the accompanying diagrammatic drawings in which:
Figure 1 is a diagrammatic side elevation of a motor vehicle;
Figure 2 is a perspective elevation of a window channel in one of the systems;
Figure 3 is a view corresponding to Figure 2 but showing an electrical contact connected to the window channel of Figure 2;
Figure 4 corresponds to Figure 3 but shows a further electrical connection;
Figure 5 is a block circuit diagram of one of the systems;
Figures 6 to 10 are cross-sections showing other possible forms of window channel which can be used in the systems;
Figures 11 to 14 are more detailed cross-sections showing further possible window channels which can be used in the systems;
Figure 15 is a detailed circuit diagram showing a circuit which can be used in another of the systems;
Figure 16 is a block circuit diagram of another form of circuit which can be used in the system;
Figure 17 is a flow chart for explaining the operation of the circuit of Figure 16; and
Figure 18 is a cross-section showing another form of window channel which can be used in another of the systems.

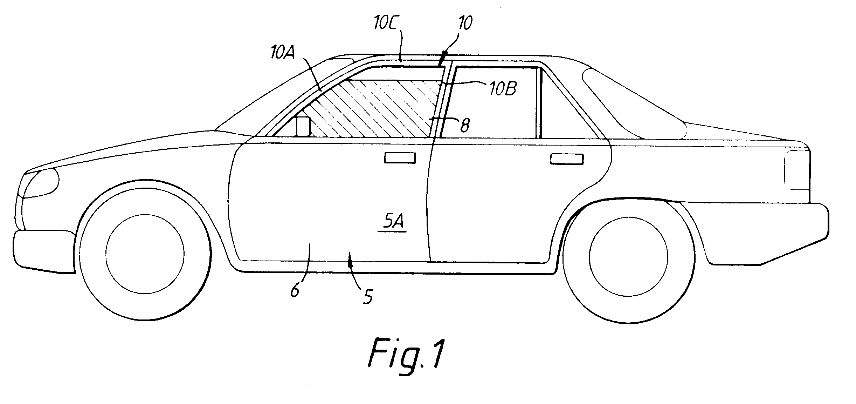

Figure 1 shows a motor vehicle 5 having a front door 6 with a power-driven window 8 which is shown cross-hatched for clarity. The power-driven window 8 is raised and lowered by means of a suitable motor, normally an electric motor, under the control of switches positioned within the vehicle for use by the driver or passenger. All or some of the other side windows in the vehicle may also be power-driven.

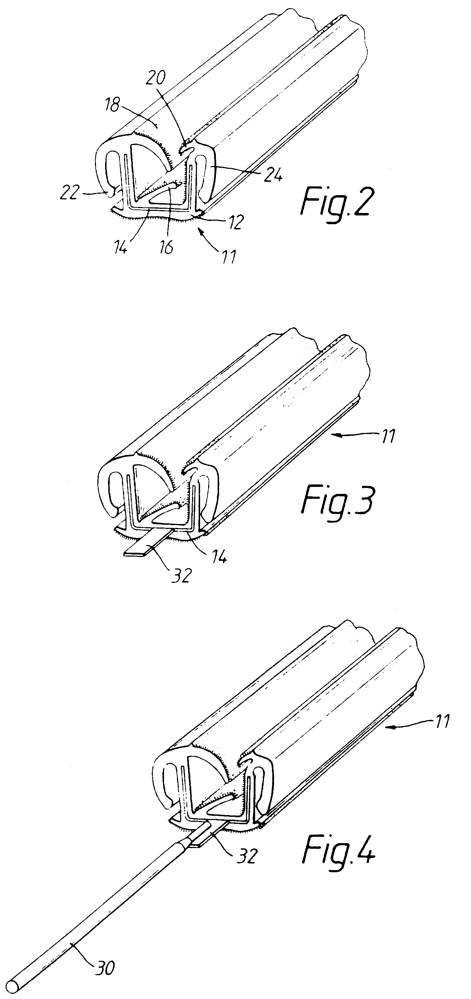

The window frame 10, forming part of the vehicle door, incorporates a window guide channel 11, one form of which is shown in Figure 2. The window channel comprises extruded plastics or rubber material 12 of channel-shape which incorporates an embedded metal core or carrier 14.

The carrier 14 may take any suitable form. For example, it may comprise a simple channel of metal. The channel could additionally be formed with apertures to increase its flexibility. Instead, the carrier could be made from U-shaped metal elements arranged side-by-side to define the channel and either connected together by short flexible interconnecting links or entirely disconnected from each other. The metal could be steel or aluminium, for example.

Instead, the carrier could be made of metal wire looped to and fro to define the channel.

The carrier is advantageously incorporated into the extruded material 12 by a known cross-head extrusion process.

The extruded material defines a lip 16 projecting upwardly from the base of the channel, a large lip 18 directed inwardly into the channel from one edge of the channel's mouth, and a similar lip 20 on the opposite side of the channel but of shorter extent.

The window frame 10 (Figure 1) may take the form of a metal channel which is sized to receive the guide channel 11 of Figure 2. When the channel 11 is fitted into position within this frame, lips 22 and 24 (Fig. 2) overlap and grip the outsides of the frame.

The window channel 11 extends around the sides and top of the frame 10. Thus, it extends up that part 10A of the frame alongside the "A" pillar of the vehicle, along the top 10C of the frame and down that part 10B of the frame corresponding to the "B" pillar. Where the window glass 8 slides into and out of the lower part 5A of the door 5, a waist-seal (not shown) is provided on each side of the slot.

The surfaces of the window channel 11, and of the waist-seal, which contact the sliding glass are advantageously covered in flock or other suitable material to provide a low-friction and substantially weather-proof surface.

In the usual way, when the driver or a passenger wishes to raise or lower the window, he or she achieves this by operating an appropriate switch which energises the motor, and the window glass thus slides upwardly or downwardly within the window guide channel 11.

The system now to be described is for automatically stopping upward movement of the window glass 8 if the driver or passenger, or someone outside the vehicle, should inadvertently place a hand or other body part within the gap between the upper edge of the window glass 8 and the top of the window frame 10C. In a manner to be explained, if such a hand or body part comes within a predetermined distance of the top part 10C of the window frame (such as it might do if it were carried upwardly by the power-driven window glass), the system automatically stops the motor, by disconnecting its energisation, before the hand or other body part becomes injured by being trapped between the top edge of the glass and the window frame 10C.

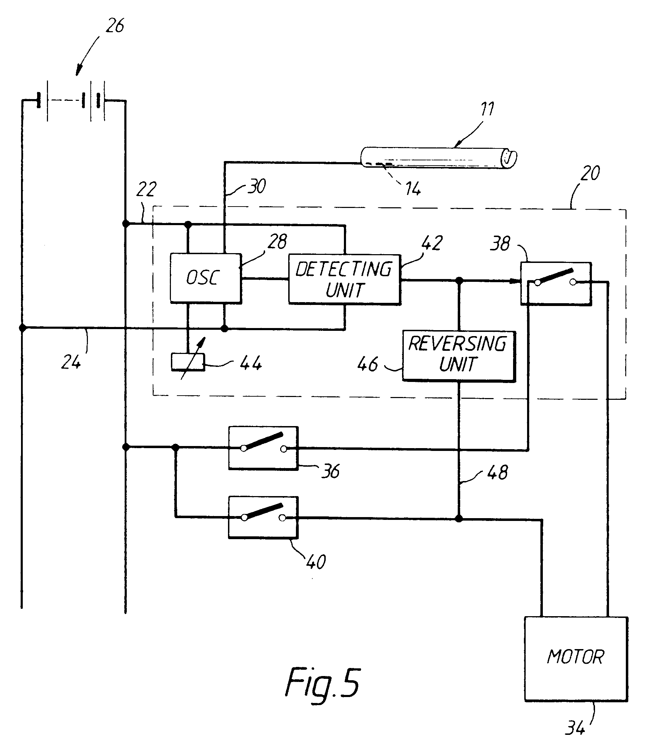

As shown in Figure 5, the vehicle carries a control unit 20 which is supplied with electrical power on lines 22 and 24 from the vehicle's battery 26. The control unit 20 includes an oscillator 28 which produces a high frequency oscillating output on a line 30. Line 30 is connected to the metal carrier 14 within the window channel 11 (Fig. 2). The connection 30 may be made to the carrier 14 in any suitable way. Figure 3 shows how the carrier 14 may be provided with a contact 32. Figure 4 shows how the connection 30 is connected to the contact 32.

Advantageously, the metal carrier within the window guide channel 11 where it runs along the top part 10C of the window frame (Fig. 1) is separated from the carrier 14 in those parts of the window guide channel 11 fitted to the parts 10A and 10B of the window frame.

It will be understood that the extruded plastics or rubber material 12 electrically insulates the carrier 14 from the vehicle bodywork, and the contact 32 and the conductor 30 (Figs. 3 and 4) are similarly insulated from the vehicle bodywork.

Figure 5 also shows the circuit for energising the electric motor 34 for raising and lowering the window glass 8. The motor 34 is energised by means of a "up" switch 36 which is positioned for use by the driver or passenger. When the switch 34 is closed, the motor 34 is electrically energised through a further switch 38 forming part of the control unit 20. Switch 38 is normally closed. Closure of switch 36 therefore energises the motor 34, and the window glass thus begins to move upwards.

Switch 36 may be a solenoid-operated switch or a solid state switch.

A second switch 40 is provided for the driver or passenger, and is used for causing the motor 34 to lower the window glass. The output of switch 40 is connected directly to the motor 34 and not via the normally-closed switch 38.

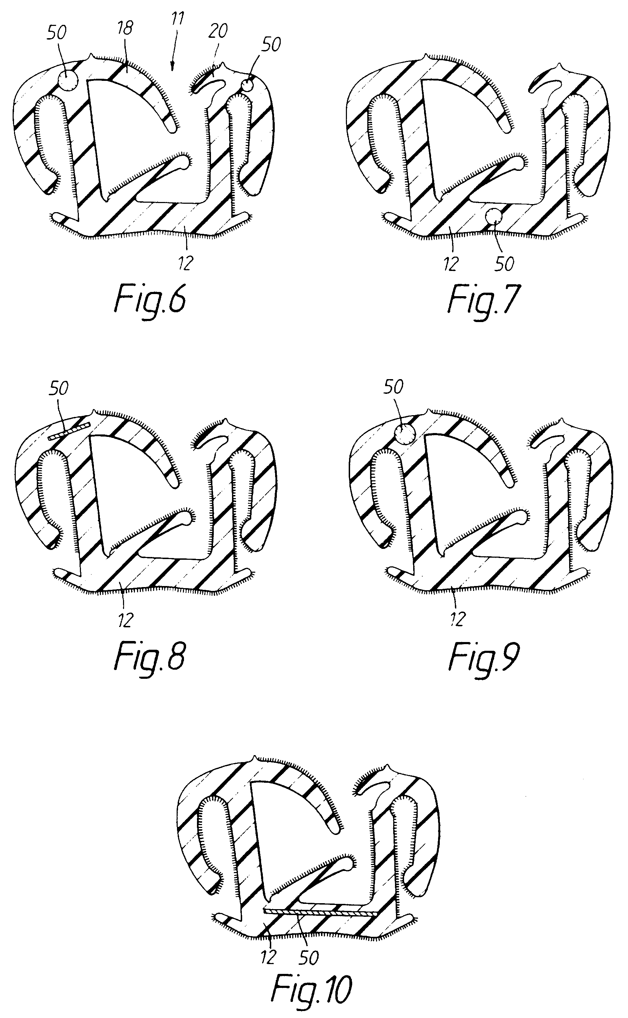

When the system is energised in the manner described, an electric field is radiated by the carrier 14 and is present within the area of the window frame. If a human hand or other body part becomes present within this radiated field, the effect will be to cause a capacitive change to be sensed by conductor 30 because of the change in dielectric constant which results from the presence of the hand or other body part. This change in capacitance will be imposed on the circuitry of the oscillator 28 and will result in a significant change in its output - in the frequency and/or amplitude and/or phase of its output. This change is detected by a detector circuit 42 (Fig. 10) which responds by opening the switch 38.

Therefore, when at least a predetermined amount of change in the output of the oscillator 28 occurs, switch 38 opens - that is, becomes open-circuit. The electrical supply to motor 34 is thus interrupted and the motor stops. Upward movement of the glass ceases and injury to the hand or other body part is prevented.

The oscillator 28 may be provided with an adjusting device 44 which adjusts the output power of the oscillator 28. This effectively adjusts the range over which the system can detect the present of a human hand or other body part within the window frame. The control 44 needs to be set so that the system will ensure that the rising window will be halted before injury occurs. The system can be set so that the rising window is stopped before the hand or other body part actually makes contact with the top 10C of the window frame. Instead, it can be set so that the window stops when the hand or other body part is in actual contact with the top 10C but before the rising window applies more than a predetermined and non-injurious force to the hand or other body part (e.g. 100 N).

Figure 5 shows how the control unit 20 may incorporate a reversing unit 46 which responds to the detected output from detector 42 by providing an output on a line 48 which reverses the motor 34, so as to cause it to lower the window.

The rising window glass on its own (that is, when no human hand or other body part is present in the gap between the glass and the top 10C of the window frame) does not itself significantly affect the output of the oscillator 28. This is because the dielectric constant of the window glass is many times less than that of a human hand or other body part.

The system can be adapted for frameless windows. In this case, there is no separate window frame. The rising and lowering window glass slides with respect to a seal or channel carried by the frame on the vehicle body within which the door is located. This channel or seal (such as a door seal) will normally also incorporate a metal carrier which can thus be connected to receive the output of the oscillator 28 in the manner already explained. If it does not incorporate such a metal carrier, a suitable electrical conducting strip may be mounted adjacent to it and suitably insulated from the vehicle body.

Figures 6 to 10 show other forms of window channel 11. In these forms, in some of which no separate metal carrier is provided, one or more electrical conductors 50 may be embedded within the extruded plastics or rubber material 12 as indicated. Again, such conductors 50 are electrically insulated by the extruded plastics or rubber material 12 from the vehicle bodywork. It will be understood that the actual configuration of the extruded plastics or rubber material of the window channels illustrated will vary according to the particular application.

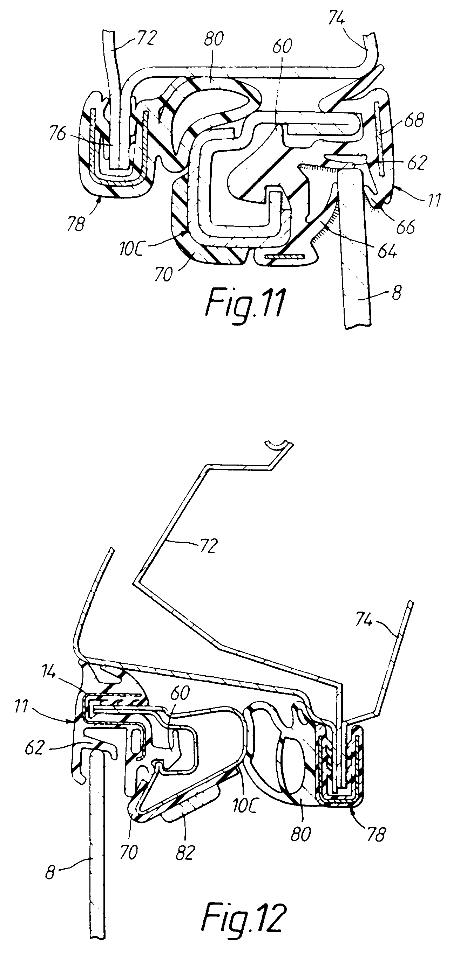

Figure 11 shows a cross-section through the top 10C of the window frame, showing, also, the window channel 11 mounted in position. The window channel 11 shown in Figure 11 differs somewhat in configuration from that shown in the previous Figures. In Figure 11, the window channel 11 is made from plastics or rubber material and has a portion 60 which is clipped into the window frame 10C and holds the window channel in position. In addition, it has lips 62,64 and 66 which contact the rising window glass 8 and advantageously have flocked surfaces. As shown in Figure 11, the window channel is provided with a metallic strip 68 and also with a metal band 70, both of which are embedded within the plastics or rubber material. One or both of these metal pieces is connected to receive the output from the oscillator 28 (Fig. 5).

Figure 11 also shows part of the trim 70 on the inside of the window frame, together with parts of the body panels 72 and 74 where they meet at the frame surrounding the door opening so as to define a flange 76. A door seal 78 incorporates a channel-shaped gripping part which embracingly grips the flange 76 and supports a door seal 80 which is sealingly contacted by the frame 10C when the door closes.

Figure 12 shows a modified form of the arrangement shown in Figure 11 and corresponding parts are similarly referenced. In this case, the window frame 11 incorporates a U-shaped carrier 14 for helping to hold the window channel on the window frame 10C. In this case, though, the metal carrier 14 is not connected to receive the output of the oscillator 28. Instead, the output of the oscillator 28 is connected to a moulding strip 82 which is mounted on the inside surface of the window frame 10C and is arranged to be electrically conductive. The strip 82 may, for example, be a metallic strip or it may be another electrical conductor incorporated within a suitable covering material. Conductive rubber could be used. It is electrically insulated from the window frame 10C by the trim material 70.

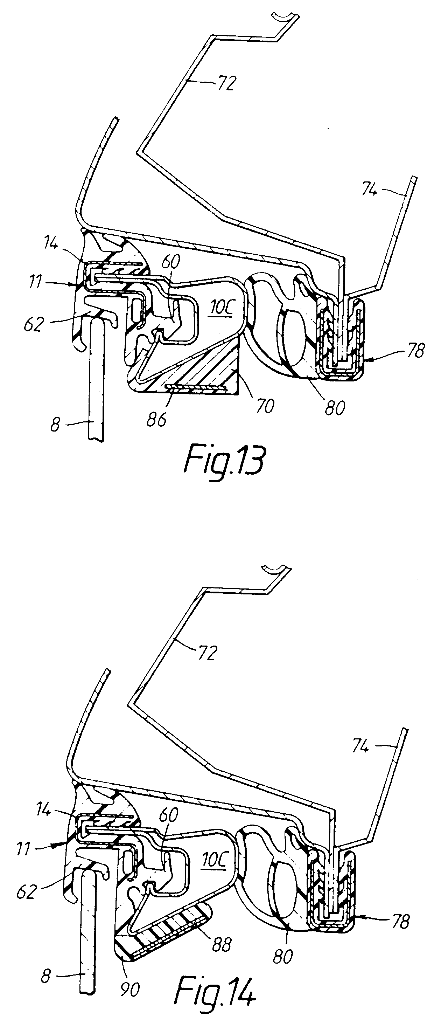

Figure 13 shows a modification to the arrangement of Figure 12, in which the trim panel 70 is differently shaped and incorporates a metallic core 86 which is connected to receive the output of the oscillator 28.

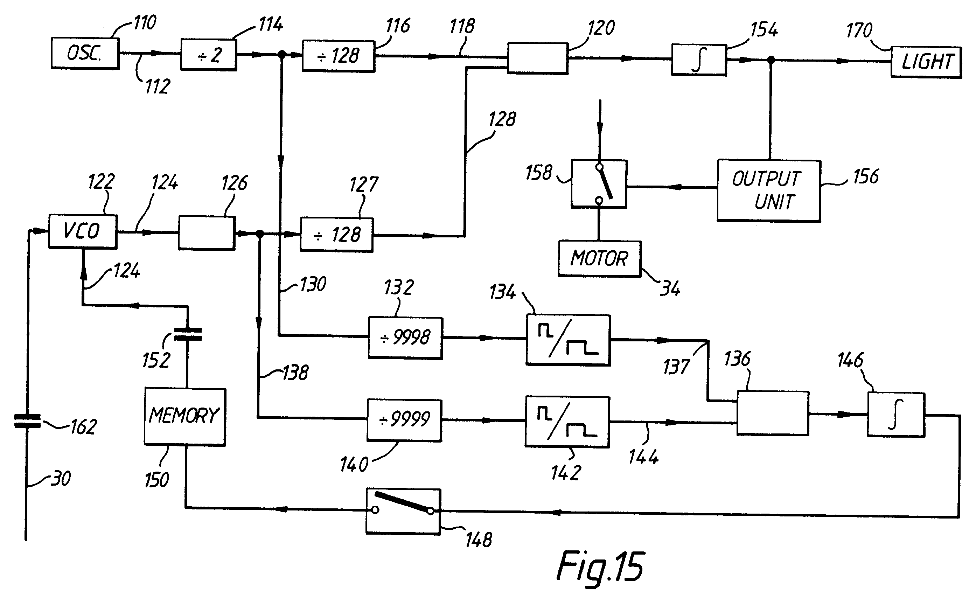

Figure 14 shows a further modification in which a metallic core 88 is fed with the output of the oscillator 28 and is mounted on the window frame 10C within electrically insulating material 90.

In the arrangements of Figures 10 to 14, the operation is as previously described. Thus, the system can be set so that the rising window is stopped before the hand or other body part actually makes contact with the conductive element 82 connected to the output of the oscillator 28, or with the insulation material covering such element; instead, however, it can be set to stop the window when the hand or body part actually makes contact with such element or insulation (but before the window applies an injurious force).

In all the cases described above, the output of the oscillator 28 is fed to electrically conductive means mounted in or adjacent to a window guide channel or strip or seal adjacent the periphery of the window frame. Instead, the output of oscillator 28 could be connected to an electrical conductor running along at least part of the top edge 8A (Fig. 1) of the window glass 8. For example, a metallic layer could be suitably deposited on the top edge 8A or an electrical wire could be embedded in the edge. In certain cases, vehicles incorporate double-glazed window panels, comprising two glass panes mounted immediately adjacent to, though separated from, each other. A metallic conductor could be incorporated within such panes, such as running along between them adjacent the top edge. The system operates in the manner generally described with reference to Figure 5. Thus, the presence of a human hand or other part of the human body on or immediately adjacent to the top edge 8A of the window glass will affect the electrical field radiated by the electrical conductor incorporated in or on the glass at that edge, resulting in activation of the detecting unit 42 in the manner described.

In these cases, suitable means would have to be provided for making the electrical connection from the output of the oscillator 28 to the electrical conductor in or adjacent to the top edge 8A of the window glass. For example, the electrical conductor could be extended down the side edge of the window glass to a position within the lower part of the door where it could be arranged to slide in electrical contact with a fixed electrical conductor connected to the output of the oscillator 28 but electrically insulated from the vehicle's body. Other arrangements are, however, possible.

Figure 15 shows in more detail a different form which the control unit 20 of Figure 5 may take.

The circuit of Figure 15 has a first oscillator 110 which is quartz-stabilised and has an output frequency of (in this example) 3.27 MHz. The oscillator's output on a line 112 is divided by two in a divider 114 and then divided by 128 in a divider 116 and passed on a line 118 to one input of a phase comparator 120.

The circuit also includes a second oscillator 122, which is a voltage controlled oscillator (VCO) and whose frequency is adjustable by means of a control signal on a line 124 but is nominally at 1.6 MHz. The output frequency of the VCO 122 is fed on a line 124 through a shaping circuit 126 to a divider 127 having a division factor of 128. The output from the divider 127 is fed to the second input of the phase comparator 120 by means of a line 128.

A line 130 feeds the output from divider 114 to a further divider 132 having a division factor of 9998 and thence to a circuit unit 134 which produces a square wave signal which is fed to one input of a phase comparator 136 in a phase-locked loop by a line 137.

A line 138 connects the output from the circuit 126 to a divider 140 having a division factor of 9999. The output of this divider is fed through a circuit unit 142 which corresponds to circuit unit 134 and produces a square wave signal which is then fed on a line 144 to the second input of the phase comparator 136.

The control output of the phase comparator 136 in the phase-locked loop, dependent on the phase and frequency error between the compared signals received on lines 137 and 144, is integrated in an integrator 146 and fed through a switch 148 to a memory 150. Thence it is fed via a capacitor 152 to the line 124 where it controls the frequency of VCO 122 in a manner to be described.

The output of the phase comparator 120, dependent on the difference in phase and frequency of the signals received on lines 118 and 128 respectively, is fed through an integrator 154 to an output unit 156. Output unit 156 controls a switch 158 connected to the motor 34 which moves or slides the window glass between its closed and open positions.

Switch 148 is closed except when the window is moving in the closing direction (i.e. upwardly).

Line 30 (corresponding to the line 30 of Figure 5) connects the VCO 122 to the metal carrier 14 or to the other conductors referred to in Figures 6 - 14, for example, conductors 50,68,70,82,86 and 88.

In use, and assuming that the window is closed, switch 148 will also be closed, and the phase comparator 136 will compare the phases and the frequencies of the square wave signals respectively received on lines 137 and 144 from the oscillators 110 and 122. With the window closed, the signal received by VCO 122 from line 30 will be dependent on ambient conditions adjacent to the window (for example, temperature, moisture caused by rain and the like and other atmospheric conditions) and will tend to alter the frequency of the VCO 122 accordingly. The output of the phase comparator 136 is fed through integrator 146 and closed switch 148 to produce a control signal on line 124 which offsets the effect of such ambient conditions on the VCO and adjusts the VCO to have a fixed frequency in relation to the stable oscillator 110. The effects of weather on the circuit are thus substantially eliminated.

As soon as the window starts to close, though, switch 148 is opened as well and the phase comparator 136 no longer has any effect on the frequency of oscillator 122. The signal on line 124 now remains constant (being stored in memory 150). While the window glass is being driven to the closed position by a motor 34, the presence of a human hand or other human body part adjacent to the energised conductor 14 (Figures 2 - 4), or to the corresponding conductors in the other Figures, produces a change in the signal on line 30. This in turn will cause a change in the frequency of the VCO 122. This will be sensed by the phase comparator 120. The resultant change in the control signal produced by the comparator will be integrated by integrator 154 and fed to the output unit 156. The output unit 156 will therefore respond by opening switch 158 so as to de-energise motor 34.

In addition, the output from integrator 154 can be arranged to energise a warning light 170.

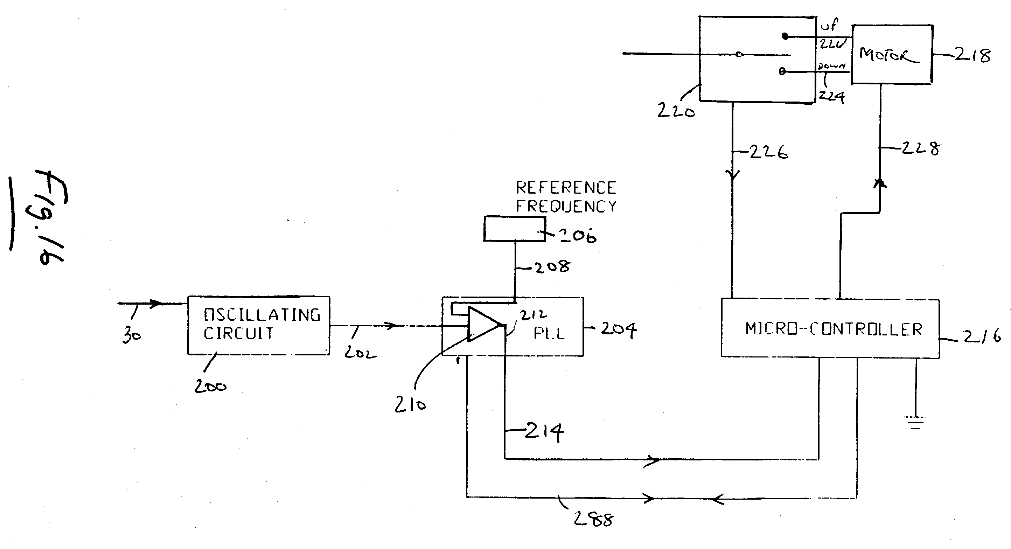

Figure 16 is a block diagram of another form which the circuit of the control unit 20 of Figure 5 may take.

The circuit of Figure 16 has a voltage controlled oscillator (VCO) 200 which is connected by a line 30 to the metal carrier 14 or to the other conductor referred to in Figures 6 - 14, for example conductors 50,68,70,82,86 and 88. Line 30 therefore effectively connects a capacitor to the VCO 200, the capacitor being formed by the conductor 50,68,70,82,86 or 88, the capacitance of this capacitor being affected by the presence of part of the human body and being connected to the VCO 200 to cause the frequency of the VCO 200 to vary in the manner already described.

The output frequency Fₒ of the VCO 200 is fed on a line 202 to a phase-locked loop 204 which also receives the output frequency Fᵣ of a reference oscillator 206 on a line 208. The phase-locked loop 204 incorporates a phase comparator shown diagrammatically at 210 which compares the phases of the outputs of the VCO 200 and the reference oscillator 206 so as to produce an output voltage on a line 212 which is dependent on the phase difference and thus on the difference in frequency between Fₒ and Fᵣ. The other elements of the phase-locked loop are not shown.

This output voltage V_{c} is fed on a line 214 to a microprocessor 216.

Figure 16 also illustrates the motor 218 which is energised under the control of the driver or a passenger in the vehicle to raise or lower the window glass. The control switch is shown at 220. The switch has an OFF or central setting in which neither of its two output lines 222 and 224 is energised. When the switch is ON and energising line 222, the motor 218 drives the window glass UP. When the switch is ON and energising line 224, the motor is energised to drive the window glass DOWN. By means of a line 226, the microprocessor 216 detects the setting of the switch 220: that is, whether it is ON or OFF and, if it is ON, whether it is causing the window glass to be driven UP or DOWN. By means of an output line 228, and in a manner to be described, the microprocessor 216 can stop the motor 218 and then energise it to drive the window glass DOWN.

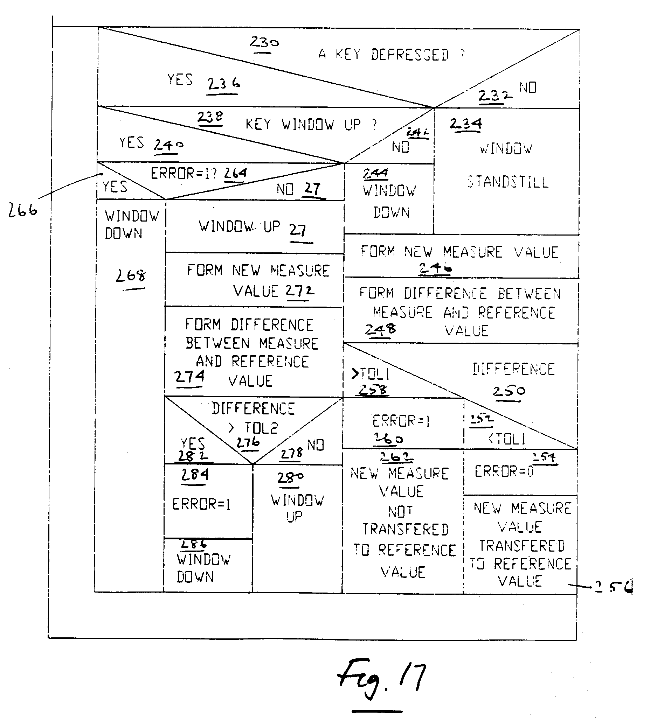

The operation of the circuit of Figure 16 will now be explained, with reference to the flow chart of Figure 17.

The microprocessor 216 repeatedly cycles through a sequence of operations.

Firstly (Stage 230, Figure 17), it determines the state of switch 220 by means of line 226 (Figure 16). If it determines that switch 20 is OFF (Stage 232), this indicates, of course, that the window glass is stationary (Stage 234).

If it determines (Stage 236) that the switch 220 is ON, the microprocessor then checks (Stage 238) whether the switch is set to drive the window UP (Stage 240) or not (Stage 242). In the latter case, of course, this means that the window glass is moving DOWN (Stage 244).

The operation of the circuit when the window glass is at a standstill (Stage 234) or is moving down (Stage 244) is the same, and will now be considered.

The microprocessor 216 now measures the value of the control voltage V_{c} received on line 214 (Figure 16) Stage 246, Figure 17. It then compares this measured value of V_{c} with a previously stored reference value (Vᵣ - see Stage 248). The value of the resultant difference is then assessed (Stage 250) by the microprocessor 216 against a tolerance value, "Tol 1".

This measured difference will be dependent, of course, on changes in the frequency Fₒ of the VCO 200. Such frequency variations will depend on various factors. As already explained, the VCO frequency Fₒ will be affected by ambient conditions adjacent to the window, in particular temperature and similar effects. In addition, of course, the VCO frequency Fₒ will be affected by the presence of a human hand or other human body part adjacent to the window opening.

If the measured difference (Stage 250) is less than Tol 1 (Stage 252), thus indicating a relatively small change in the VCO frequency Fₒ, this is interpreted as a change caused by variation in temperature or other ambient effect. A measured difference of less than Tol 1 is considered to have an "error value" of zero (Stage 254). In response to detection of a zero error value, the microprocessor stores the new measured value of the control voltage on line 214 to form a new reference value Vᵣ (Stage 256).

If, however, the measured difference (Stage 250) between the actual value V_{c} of the control voltage and the stored reference value Vᵣ is greater than Tol 1 (Stage 258), the "error value" is assessed at "1" (Stage 260). The system interprets this as indicating that a hand or other human body part is present in or near the window opening. The new measured value of V_{c} is therefore not transferred to become the new reference value Vᵣ (Stage 262). No other action is taken in response to this detection of part of the human body in the window opening - because, of course, the window glass is either moving down or is stationary.

In this way, for so long as the window glass is stationary or moving down, the microprocessor 216 repeatedly assesses the value of the control voltage V_{c} and compares it with the previously stored value Vᵣ. Adjustments in Vᵣ are made to take account of temperature and similar environmental effects. The stored value Vᵣ thus continuously represents the frequency of the VCO 200.

If (Stage 240) the microprocessor detects that the switch 220 is causing the window to be driven UP, the microprocessor immediately assesses whether the difference between the measured value V_{c} of the control voltage differs from the currently stored reference value Vᵣ sufficiently to produce a value "1" (Stage 264) for the error value. If the error value is 1 (Stage 266), this indicates that a sufficient change in the frequency Fₒ of the VCO 200 has occurred to indicate the presence of a human body part in the window opening. The microprocessor therefore energises line 228 (Figure 16) to cause the motor 218 to stop and then drive the window glass DOWN (Stage 268).

However, if (Stage 270) the assessed error value is not "1", the window continues to be driven UP by the motor 218 (Stage 271). The microprocessor then measures the value of V_{c} again (Stage 272) and assesses the difference (Stage 274) between this new measured value and the stored value of Vᵣ. The system then assesses whether this difference is greater or less than a tolerance value "Tol 2" (Stage 276). Tol 2 is set as a threshold value such that an assessed difference greater than Tol 2 indicates the presence of a human body part in the window opening. If the assessed difference is less than Tol 2 (Stage 278), the window continues to be driven UP (Stage 280). However, if the assessed difference is greater than Tol 2 (Stage 282), this is interpreted as an "error value" of "1" (Stage 284) and the microprocessor therefore energises line 228 (Figure 16) to stop the motor 218 and to cause it to drive the window DOWN.

Because the system continuously adjusts the reference value Vᵣ to take account of temperature and similar ambient parameters, these parameters are substantially offset and do not affect the detection of the presence of part of the human body in the window opening.

The microprocessor 216 may be connected to the phase locked loop 214 by other data transfer lines indicated generally at 288 for control and operational purposes.

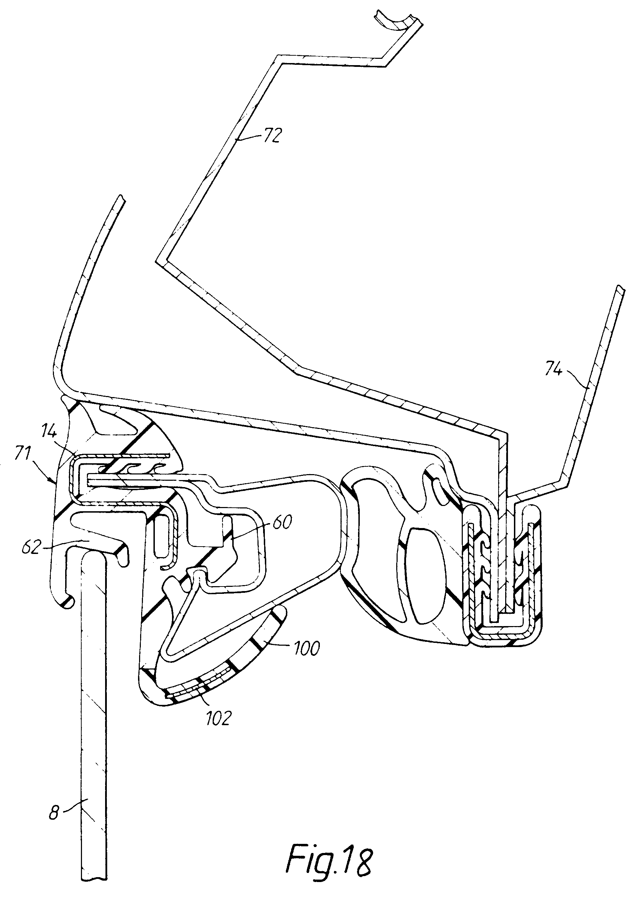

Figure 18 is a cross-section through another form of window channel which is used in a modified form of the system. Parts in Figure 18 corresponding to those in other Figures are similarly referenced.

In the system of Figure 18, the extruded material defining one side of the window channel is extended to form a flexible lip 100 incorporating a metal carrier or conductor 102. This may be in the form of a metal strip, possibly apertured or slotted to increase its flexibility. Instead, however, a metal wire could be used.

In the system of Figure 18, the conductor 102 constitutes one plate of a capacitor forming part of the tuned circuit of the oscillator 28, and an appropriate connection to the conductor 102 is made from the oscillator tuned circuit accordingly. The lip 100 is so positioned in relation to the window glass 8 that a human hand or other human body part on the rising edge of the window glass 8 will make contact with the lip 100 as the window glass rises to the closed position, and will alter the position of the lip 100 because of the latter's flexibility. The consequent movement of the metal conductor 102 will cause a significant change in the capacitance in the tuned circuit of the oscillator 28. An abrupt and significant change in the oscillator frequency will therefore take place and this will be detected by the detecting unit 42 (Fig. 5) and thus immediately stop the rising window glass. In the normal position of the lip 100 (that is, when not contacted by any external object such as a human hand or other body part), the capacitance in the tuned circuit of the oscillator 28 is such that its output frequency does not activate the detecting unit 42, and the motor 34 for driving the window glass can thus operate normally.

The system of Figure 18 is advantageous in that the change in the oscillator output frequency, in response to the human hand or other body part, can be more substantial and easier to detect than is the case with the systems described with reference to the previous Figures. The system of Figure 18 may therefore be less sensitive to extraneous effects and easier to adjust. In addition, the circuit can be simpler.

The systems are advantageous in that they require only a single electrical connection and require little or no modification to the window arrangement. Existing vehicles can be easily modified. There are no wearing parts. Most forms of existing window guide channels can be adapted for use in the system. The system is robust and needs no extra space and can be inexpensive.

The other power-driven windows of the vehicle may be controlled in the same way.

The systems described may of course be used to control horizontally slidable power-driven windows instead. They may also be used to control angularly movable power-driven windows.

## Claims

1. A system for controlling a power-driven window (8) movable in a window opening (10) between closed and opened positions, comprising electrical oscillating means (122;200) for producing an electrically oscillating output, electrically conductive means (14,50,68,70,82,86,88,102) adapted to be positioned adjacent to the window opening (10), connecting means (30) connecting the conductive means (14,50,68,70,82,86,88,102) to the electrical oscillating means (122;200) such that the presence of a part of the human body at or not more than a predetermined distance from the electrically conductive means (14,50,68,70,82,86,88,102) produces a change in the frequency of the electrically oscillating output, detecting means (120;216) responsive to the said change in frequency to produce an output signal, and output means responsive to the output signal for interrupting movement of the window glass (80) towards the closed position, characterised in that the detecting means comprises a source (110;206) producing a reference frequency, and comparing means (120;210) for comparing the frequency of the electrically oscillating output with the reference frequency to produce the said output signal.

2. A system according to claim 1, characterised in that the comparing means comprises a comparator within a phase-locked loop (136;204).

3. A system according to claim 1, characterised by adjusting means (136,146,148;216,220) for offsetting the effect on the frequency of the electrically oscillating output of conditions adjacent to the electrically conductive means (14,50,68,70,82,86,88,102) other than caused by the presence of the said part of the human body.

4. A system according to claim 3, characterised in that the adjusting means comprises comparing means (136) operative when the window glass is not moving towards the closed position to compare the frequency of the electrically oscillating output with a reference frequency whereby to produce a comparison signal dependent on the difference between the compared frequencies, and means connecting the comparison signal to adjust the frequency of the electrically oscillating means (122) to tend to equalise the compared frequencies.

5. A system according to claim 3, characterised in that the adjusting means comprises comparing means (210) operative when the window glass is not moving towards the closed position to compare the frequency of the electrically oscillating output from the electrical oscillating means (200) with a reference frequency whereby to produce a comparison signal (V_{c}) dependent on the difference between the compared frequencies, means responsive to the value of the comparison signal (V_{c}) to compare it with a previously stored reference value (Vᵣ) to assess whether the difference between the comparison signal (V_{c}) and the reference (Vᵣ) is greater or less than a predetermined tolerance level, and means operative to store the value of the comparison signal (Vᵣ) as the new value for the reference value (Vᵣ) only if the said difference is less than the predetermined tolerance level, the detecting means (216) being operative to produce the said output signal when the window glass is moving towards the closed position and the difference between the comparison signal (V_{c}) and the reference value (Vᵣ) indicates the said presence of part of the human body.

6. A system according to claim 4, characterised in that the comparing means (136;210) of the adjusting means is a comparator in a phase-locked loop (136;204) receiving the reference frequency.

7. A system according to claims 2 and 6, characterised in that each reference frequency is derived from a common stable frequency source (110).

8. A system according to any preceding claim, characterised in that the electrical oscillating means (122;200) has a tuned circuit in which is connected the electrically conductive means (102), the conductive means (102) being movably mounted so as to be moved by direct or indirect contact with the said part of the human body to produce a change in frequency of the oscillating output.

9. A system according to any preceding claim, characterised in that the window (8) is slidable relative to a sealing or guiding member (e.g. 11), the sealing or guiding member incorporating the electrically conductive means (14,50,68,70,82,86,88,102).

10. A system according to claim 9, characterised in that the sealing or guiding member (11) is made of plastics or rubber material and the electrically conductive means comprises an electrical conductor (14,50,68,70,82,86,88,102) embedded within the plastics or rubber material.

11. A system according to claim 10, characterised in that the electrical conductor is a metal carrier (14).

12. A system according to any one of claims 9 to 11, characterised in that the sealing or guiding member (11) is attached to a frame for the window.

13. A system according to any one of claims 9 to 11, characterised in that the window (8) is mounted within the door (5) of a motor vehicle and in that the sealing or guiding member (11) is mounted on or adjacent to a frame for the door.

14. A system according to any one of claims 1 to 7, characterised in that the window (8) is slidable relative to a sealing or guiding member (11) and the electrically conductive means is adjacent to but separate from the sealing or guiding member (11).

15. A system according to any one of claims 1 to 7, characterised in that the electrically conductive means is mounted on or adjacent to an edge of the window glass.

16. A system according to claim 15, characterised in that the electrically conductive means comprises a metal coating on the edge of the window glass.

17. A system according to claim 15 or 16, characterised in that the window glass is a double-glazed window glass.

18. A system according to any preceding claim, characterised in that the window glass (8) is driven by an electric motor (34) and the output means comprises a switch (38,158) for interrupting energisation of the motor (34).

19. A system according to any preceding claim, characterised in that the output means includes means (40) responsive to the control signal for causing the window glass (8) to reverse its sliding direction.

20. A system for controlling a power-driven window glass (8) slidable in a window frame (10), comprising electrically conductive means (102) adapted to be mounted in use adjacent to the window opening (10) so as to be physically moved by direct or indirect contact with part of the human body positioned between the moving window glass and its frame during power-driven closure of the window, electrical circuit means (28,110) connected to the electrically conductive means (102) so as to respond to the said movement of the electrically conducted means (102) and to produce a corresponding output, detecting means responsive to the output to produce a control signal, and control means responsive to the control signal for interrupting power-driven movement of the window glass (8), characterised in that the electrical circuit means incorporates an electrical oscillator (28,110) and in that the electrically conductive means (102) is connected in the tuned circuit of the oscillator (28,110) whereby the said movement of the electrically conductive means (102) changes the frequency of the oscillator to produce the said output.

21. A system according to claim 20, characterised in that the electrically conductive means (102) is incorporated within flexible electrically insulating material (100).

22. A system according to claim 21, characterised in that the electrically conductive means (102) and the flexible insulating material (100) together form part of a sealing or guiding member.

23. A system according to any one of claims 20 to 22, characterised in that the electrically conductive means (102) is a metal carrier.

24. A system according to any one of claims 20 to 23, characterised in that the power-driven window glass (8) is driven by an electric motor (34) and the control means comprising a switch (38) for interrupting energisation of the motor (34).

25. A system according to any one of claims 20 to 24, characterised in that the control means includes means (40) responsive to the control signal for causing the window glass to reverse its sliding direction.

## Patentansprüche

1. System zur Steuerung eines mit einem Motor betriebenen Fensters (8), das in einer Fensteröffnung (10) zwischen geschlossenen und geöffneten Positionen bewegbar ist, mit einem elektrischen Schwingmittel (122; 200) zur Erzeugung eines elektrischen Schwingungs-Ausgabesignals, elektrischen Leitungsmitteln (14, 50, 68, 70, 82, 86, 88, 102), die daran angepaßt sind, in der Nähe der Fensteröffnung (10) angeordnet zu werden, einem Verbindungsmittel (30), das die Leitungsmittel (14, 50, 68, 70, 82, 86, 88, 102) an das elektrische Schwingmittel (122; 200) anschließt, so daß die Gegenwart eines Teils des menschlichen Körpers an den oder nicht weiter als ein vorbestimmter Abstand entfernt von den elektrischen Leitungsmitteln (14, 50, 68, 70, 82, 86, 88, 102) eine Änderung der Frequenz des elektrischen Schwingungs-Ausgabesignals erzeugt, einem Erfassungsmittel (120; 216), das auf die Frequenzänderung anspricht, um ein Ausgangssignal zu erzeugen, sowie mit einem Ausgabemittel, das auf das Ausgangssignal anspricht, um die Bewegung der Fensterscheibe (8) in Richtung auf die geschlossene Position zu unterbrechen,
**dadurch gekennzeichnet,**
daß das Erfassungmittel eine eine Referenzfrequenz erzeugende Quelle (110; 206) sowie ein Vergleichsmittel (120; 210) umfaßt, um die Frequenz des elektrischen Schwingungs-Ausgangssignals mit der Referenzfrequenz zu vergleichen, um das Ausgangssignal zu erzeugen.

2. System nach Anspruch 1, dadurch gekennzeichnet, daß das Vergleichsmittel einen Vergleicher innerhalb einer phasenstarren Ringbahn (136; 204) umfaßt.

3. System nach Anspruch 1, gekennzeichnet durch Stellmittel (136, 146, 148; 216, 220) zum Ausgleichen des Einflusses auf die Frequenz des elektrischen Schwingungs-Ausgabesignals auf Bedingungen in der Nähe der elektrischen Leitungsmittel (14, 50, 68, 70, 82, 86, 88, 102), anders als der, bewirkt durch die Gegenwart eines Teils des menschlichen Körpers.

4. System nach Anspruch 3, dadurch gekennzeichnet, daß das Stellmittel ein Vergleichsmittel (136) umfaßt, das wirksam wird, wenn sich die Fensterscheibe nicht in Richtung der geschlossenen Position bewegt, um die Frequenz des elektrischen Schwingungs-Ausgabesignals mit einer Referenzfrequenz zu vergleichen, um dadurch abhängig von der Differenz zwischen den verglichenen Frequenzen ein Vergleichssignal zu erzeugen, sowie Mittel umfaßt, die das Vergleichssignal anschließen, um die Frequenz des elektrischen Schwingungsmittels (122) einzustellen, um darauf abzuzielen, die verglichenen Frequenzen zu glätten.

5. System nach Anspruch 3, dadurch gekennzeichnet, daß das Einstellmittel ein Vergleichsmittel (210) umfaßt, das wirksam wird, wenn sich die Fensterscheibe nicht in Richtung der geschlossenen Position bewegt, um die Frequenz des elektrischen Schwingungs-Ausgabesignals des elektrischen Schwingmittels (200) mit einer Referenzfrequenz zu vergleichen, um dadurch in Abhängigkeit von der Differenz zwischen den verglichenen Frequenzen ein Vergleichssignal (V_{c}) zu erzeugen, sowie mit Mitteln, die auf den Wert des Vergleichssignals (V_{c}) ansprechen, um diesen mit einem vorher gespeicherten Referenzwert (Vᵣ) zu vergleichen, um festzustellen, ob die Differenz zwischen dem Vergleichssignal (V_{c}) und dem Referenzwert (Vᵣ) größer oder kleiner als ein vorbestimmter Toleranzpegel ist, sowie mit Mitteln, die wirksam sind, um den Wert des Vergleichssignals (V_{c}) als den neuen Wert für den Referenzwert (Vᵣ) zu speichern, aber nur, wenn die Differenz kleiner als der vorbestimmte Toleranzpegel ist, und das Erfassungsmittel (216) wirksam wird, um das Ausgangssignal zu erzeugen, wenn die Fensterscheibe sich in Richtung der geschlossenen Position bewegt und die Differenz zwischen dem Vergleichssignal (V_{c}) und dem Referenzwert (Vᵣ) die Gegenwart eines Teils des menschlichen Körpers anzeigt.

6. System nach Anspruch 4, dadurch gekennzeichnet, daß das Vergleichsmittel (136; 210) des Einstellmittels ein Vergleicher in einer phasenstarren Ringbahn (136; 204) ist, der die Referenzfrequenz empfängt.

7. System nach Anspruch 2 und 6, dadurch gekennzeichnet, daß jede Referenzfrequenz von einer allgemein stabilen Frequenzquelle (110) abstammt.

8. System nach einem der vorhergehenden Ansprüche, dadurch gekennzeichnet, daß das elektrische Schwingmittel (122; 200) einen abgestimmten Schwingkreis aufweist, in den das elektrische Leitungsmittel (102) geschaltet ist, wobei das Leitungsmittel (102) beweglich angeordnet ist, um bei direktem oder indirektem Kontakt mit dem besagten Teil des menschlichen Körpers bewegt zu werden, um eine Frequenzänderung des Schwingungs-Ausgabesignals zu erzeugen.

9. System nach einem der vorhergehenden Ansprüche, dadurch gekennzeichnet, daß das Fenster (8) relativ zu einem Dichtungs- oder Führungsteils (z. B. 11) verschiebbar ist, wobei das Dichtungs- oder Führungsteil die elektrischen Leitungsmittel (14, 50, 68, 70, 82, 86, 88, 102) einschließt.

10. System nach Anspruch 9, dadurch gekennzeichnet, daß das Dichtungs- oder Führungsteil (11) aus einem Kunststoff- oder Gummimaterial hergestellt ist und die elektrischen Leitungsmittel einen elektrischen Leiter (14, 50, 68, 70, 82, 86, 88, 102) umfassen, der in das Kunststoff- oder Gummimaterial eingebettet ist.

11. System nach Anspruch 10, dadurch gekennzeichnet, daß der elektrische Leiter ein Metallträger (14) ist.

12. System nach einem der Ansprüche 9 bis 11, dadurch gekennzeichnet, daß das Dichtungs- oder Führungsteil (11) an einen Rahmen für das Fenster angefügt ist.

13. System nach einem der Ansprüche 9 bis 11, dadurch gekennzeichnet, daß das Fenster (8) in der Tür eines Kraftfahrzeuges angeordnet ist und daß das Dichtungs- oder Führungsteil auf oder angrenzend an einen Rahmen für die Tür befestigt ist.

14. System nach einem der Ansprüche 1 bis 7, dadurch gekennzeichnet, daß das Fenster (8) relativ zu einem Dichtungs- oder Führungsteil (11) verschiebbar ist und das elektrische Leitungsmittel angrenzend, aber getrennt von dem Dichtungs- oder Führungsteil (11) angeordnet ist.

15. System nach einem der Ansprüche 1 bis 7, dadurch gekennzeichnet, daß elektrische Leitungsmittel auf oder angrenzend an eine Kante der Fensterscheibe angeordnet ist.

16. System nach Anspruch 15, dadurch gekennzeichnet, daß das elektrische Leitungsmittel eine Metallbeschichtung auf der Kante der Fensterscheibe umfaßt.

17. System nach Anspruch 15 oder 16, dadurch gekennzeichnet, daß die Fensterscheibe eine doppelt verglaste Fensterscheibe ist.

18. System nach einem der vorhergehenden Ansprüche, dadurch gekennzeichnet, daß die Fensterscheibe (8) durch einen elektrischen Motor (34) angetrieben wird und das Ausgabemittel einen Schalter (38, 158) umfaßt, um die Erregung des Motors (34) zu unterbrechen.

19. System nach einem der vorhergehenden Ansprüche, dadurch gekennzeichnet, daß das Ausgabemittel ein Mittel (40) umfaßt, das auf das Steuersignal anspricht, um zu bewirken, daß die Fensterscheibe (8) ihre Gleitrichtung umkehrt.

20. System zur Steuerung einer mit einem Motor betriebenen, in einem Fensterrahmen (10) verschiebbaren Fensterscheibe (8) mit einem elektrischen Leitungsmittel (102), das daran angepaßt ist, um im Gebrauch in der Nähe der Fensteröffnung (10) angeordnet zu werden, um bei direktem oder indirektem Kontakt mit einem Teil des menschlichen Körpers, der während des motorbetriebenen Schließens des Fensters zwischen der sich bewegenden Fensterscheibe und deren Rahmen angeordnet ist, physisch bewegt zu werden, elektrischen Schaltungsmitteln (28, 110), die an das elektrische Leitungsmittel (102) angeschlossen sind, um auf die Bewegung des elektrischen Leitungsmittels (102) anzusprechen und eine entsprechendes Ausgangssignal zu erzeugen, einem Erfassungsmittel, das auf das Ausgangssignal anspricht, um ein Steuerungssignal zu erzeugen, sowie mit Steuerungsmitteln, die auf das Steuerungssignal ansprechen, um die motorbetriebene Bewegung der Fensterscheibe (8) zu unterbrechen,
**dadurch gekennzeichnet,**
daß das elektrische Schaltungsmittel einen elektrischen Schwinger (28, 110) einschließt und daß das elektrische Leitungsmittel (102) in den abgestimmten Schwingkreis des Schwingers (28, 110) eingeschaltet ist, wodurch die Bewegung des elektrischen Leitungsmittels (102) die Frequenz des Schwingers ändert, um das Ausgangssignal zu erzeugen.

21. System nach Anspruch 20, dadurch gekennzeichnet, daß das elektrische Leitungsmittel (102) in ein flexibles, elektrisch isolierendes Material (100) eingelagert ist.

22. System nach Anspruch 21, dadurch gekennzeichnet, daß das elektrische Leitungsmittel (102) und das flexible Isolierungsmaterial (100) zusammen ein Dichtungs- oder Führungsteil bilden.

23. System nach einem der Ansprüche 20 bis 22, dadurch gekennzeichnet, daß das elektrische Leitungsmittel (102) ein Metallträger ist.

24. System nach einem der Ansprüche 20 bis 23, dadurch gekennzeichnet, daß die motorbetriebene Fensterscheibe (8) durch einen Elektromotor (34) angetrieben wird und das Steuerungsmittel einen Schalter (38) umfaßt, um die Erregung des Motors (34) zu unterbrechen.

25. System nach einem der Ansprüche 20 bis 24, dadurch gekennzeichnet, daß das Steuerungsmittel ein Mittel (40) umfaßt, das auf das Steuerungssignal anspricht, um zu bewirken, daß die Fensterscheibe ihre Gleitrichtung umkehrt.

## Revendications

1. Système de commande d'une fenêtre motorisée (8) mobile dans une ouverture de fenêtre (10) entre des positions fermée et ouverte, comportant des moyens d'oscillation électriques (122; 200) destinés à produire une sortie électriquement oscillante, des moyens électriquement conducteurs (14, 50, 68, 70, 82, 86, 88, 102) prévus pour être positionnés de façon adjacente à l'ouverture de fenêtre (10), des moyens de raccordement (30) reliant les moyens conducteurs (14, 50, 68, 70, 82, 86, 88, 102) aux moyens d'oscillation électriques (122; 200) de telle sorte que la présence d'une partie du corps humain au niveau de ou à pas plus d'une distance prédéterminée des moyens électriquement conducteurs (14, 50, 68, 70, 82, 86, 88, 102) produit un changement dans la fréquence de la sortie électriquement oscillante, des moyens de détection (120; 216) qui répondent audit changement de fréquence afin de produire un signal de sortie, et des moyens de sortie qui répondent au signal de sortie afin d'interrompre le mouvement de la vitre (80) vers la position fermée, caractérisé en ce que les moyens de détection comportent une source (110; 206) produisant une fréquence de référence, et des moyens de comparaison (120; 210) destinés à comparer la fréquence de la sortie électriquement oscillante avec la fréquence de référence afin de produire ledit signal de sortie.

2. Système selon la revendication 1, caractérisé en ce que les moyens de comparaison comportent un comparateur dans une boucle à verrouillage de phase (136; 204).

3. Système selon la revendication 1, caractérisé par des moyens de réglage (136, 146, 148; 216, 220) destinés à décaler l'effet sur la fréquence des conditions de sortie électriquement oscillantes adjacentes aux moyens électriquement conducteurs (14, 50, 68, 70, 82, 86, 88, 102) autres que ce qui est provoqué par la présence de ladite partie du corps humain.

4. Système selon la revendication 3, caractérisé en ce que les moyens de réglage comportent des moyens de comparaison (136) opérationnels lorsque la vitre ne se déplace pas vers la position fermée afin de comparer la fréquence de la sortie électriquement oscillante avec une fréquence de référence de façon à produire un signal de comparaison dépendant de la différence entre les fréquences comparées, et des moyens reliant le signal de comparaison afin de d'ajuster la fréquence des moyens électriquement oscillants (122) de façon à tendre à égaliser les fréquences comparées.

5. Système selon la revendication 3, caractérisé en ce que les moyens de réglage comportent des moyens de comparaison (210) opérationnels lorsque la vitre ne se déplace pas vers la position fermée afin de comparer la fréquence de la sortie électriquement oscillante des moyens d'oscillation électriques (200) avec une fréquence de référence de façon à produire un signal de comparaison (V_{c}) qui dépend de la différence entre les fréquences comparées, des moyens qui répondent à la valeur du signal de comparaison (V_{c}) afin de le comparer à une valeur de référence stockée au préalable (Vᵣ) de façon à estimer si la différence entre le signal de comparaison (V_{c}) et la référence (Vᵣ) est supérieure ou inférieure à un niveau de tolérance prédéterminé, et des moyens opérationnels afin de stocker la valeur du signal de comparaison (Vᵣ) en tant que nouvelle valeur pour la valeur de référence (Vᵣ) uniquement si ladite différence est inférieure au niveau de tolérance prédéterminé, les moyens de détection (216) étant opérationnels afin de produire ledit signal de sortie lorsque la vitre se déplace vers la position fermée et la différence entre le signal de comparaison (V_{c}) et la valeur de référence (Vᵣ) indique ladite présence d'une partie du corps humain.

6. Système selon la revendication 4, caractérisé en ce que les moyens de comparaison (136; 210) des moyens de réglage sont constitués par un comparateur dans une boucle à verrouillage de phase (136; 204) recevant la fréquence de référence.

7. Système selon les revendications 2 et 6, caractérisé en ce que chaque fréquence de référence est obtenue à partir d'une source de fréquence stable commune (110).

8. Système selon l'une quelconque des revendications précédentes, caractérisé en ce que les moyens d'oscillation électriques (122; 200) possèdent un circuit accordé auquel sont reliés les moyens électriquement conducteurs (102), les moyens conducteurs (102) étant montés de façon mobile afin d'être déplacés par contact direct ou indirect avec ladite partie du corps humain de façon à produire un changement de fréquence de la sortie oscillante.

9. Système selon l'une quelconque des revendications précédentes, caractérisé en ce que la fenêtre (8) peut coulisser par rapport à un élément d'étanchéité ou de guidage (par exemple 11), l'élément d'étanchéité ou de guidage incorporant les moyens électriquement conducteurs (14, 50, 68, 70, 82, 86, 88, 102).

10. Système selon la revendication 9, caractérisé en ce que l'élément d'étanchéité ou de guidage (11) est fabriqué en matière plastique ou en caoutchouc et les moyens électriquement conducteurs comportent un conducteur électrique (14, 50, 68, 70, 82, 86, 88, 102) noyé dans la matière plastique ou le caoutchouc.

11. Système selon la revendication 10, caractérisé en ce que le conducteur électrique est un support métallique (14).

12. Système selon l'une quelconque des revendications 9 à 11, caractérisé en ce que l'élément d'étanchéité ou de guidage (11) est fixé sur un encadrement de la fenêtre.

13. Système selon l'une quelconque des revendications 9 à 11, caractérisé en ce que la fenêtre (8) est montée dans la porte (5) d'un véhicule à moteur et en ce que l'élément d'étanchéité ou de guidage (11) est monté sur ou de façon adjacente à un encadrement de la porte.

14. Système selon l'une quelconque des revendications 1 à 7, caractérisé en ce que la fenêtre (8) peut coulisser par rapport à l'élément d'étanchéité ou de guidage (11) et les moyens électriquement conducteurs sont adjacents mais séparés de l'élément d'étanchéité ou de guidage (11).

15. Système selon l'une quelconque des revendications 1 à 7, caractérisé en ce que les moyens électriquement conducteurs sont montés sur ou de façon adjacente à un bord de la vitre.

16. Système selon la revendication 15, caractérisé en ce que les moyens électriquement conducteurs comportent un revêtement en métal sur le bord de la vitre.

17. Système selon la revendication 15 ou 16, caractérisé en ce que la vitre est une vitre à double vitrage.

18. Système selon l'une quelconque des revendications précédentes, caractérisé en ce que la vitre (8) est entraînée par un moteur électrique (34) et les moyens de sortie comportent un contacteur (38, 158) destiné à interrompre l'activation du moteur électrique (34).

19. Système selon l'une quelconque des revendications précédentes, caractérisé en ce que les moyens de sortie comprennent des moyens (40) qui répondent au signal de commande afin d'amener la vitre (8) à inverser sa direction de coulissement.

20. Système de commande d'une vitre motorisée (8) pouvant coulisser dans un encadrement de fenêtre (10), comportant des moyens électriquement conducteurs (102) prévus pour être montés lors de l'utilisation de façon adjacente à l'ouverture de fenêtre (10) afin d'être déplaces physiquement par un contact direct ou indirect avec une partie du corps humain positionnée entre la vitre mobile et son encadrement pendant la fermeture motorisée de la fenêtre, des moyens de circuit électrique (28, 110) reliés aux moyens électriquement conducteurs (102) de façon à répondre au dit mouvement des moyens électriquement conducteurs (102) et à produire une sortie correspondante, des moyens de détection qui répondent à la sortie afin de produire un signal de commande, et des moyens de commande qui répondent au signal de commande afin d'interrompre le mouvement motorisé de la vitre (8), caractérisé en ce que les moyens de circuit électrique incorporent un oscillateur électrique (28, 110) et en ce que les moyens électriquement conducteurs (102) sont reliés dans le circuit accordé de l'oscillateur (28, 110) de sorte que ledit mouvement des moyens électriquement conducteurs (102) change la fréquence de l'oscillateur afin de produire ladite sortie.

21. Système selon la revendication 20, caractérisé entre les moyens électriquement conducteurs (102) sont incorporés dans une matière flexible électriquement isolante (100).

22. Système selon la revendication 21, caractérisé en ce que les moyens électriquement conducteurs (102) et la matière flexible isolante (100) forment ensemble une partie d'un élément d'étanchéité ou de guidage.

23. Système selon l'une quelconque des revendications 20 à 22, caractérisé en ce que les moyens électriquement conducteurs (102) sont constitués par un support métallique.

24. Système selon l'une quelconque des revendications 20 à 23, caractérisé en ce que la vitre motorisée (8) est entraînée par un moteur électrique (34) et les moyens de commande comportent un contacteur (38) destiné à interrompre l'activation du moteur (34).

25. Système selon l'une quelconque des revendications 20 à 24, caractérisé en ce que les moyens de commande comprennent des moyens (40) qui répondent au signal de commande afin d'amener la vitre à inverser sa direction de coulissement.
